# EUROPEAN PATENT APPLICATION

(11) **EP 4 492 466 A1**
(43) Date of publication of application: **15.01.2025**
(21) Application number: 23185337.5
(22) Date of filing: 13.07.2023
(51) Int. Cl.: H01L 27/142, H10N 19/00, B60L 53/22, H03K 17/00

(54) **SWITCHING ASSEMBLY FOR AN ELECTRIC CONVERTER UNIT, ELECTRIC CONVERTER UNIT, TRACTION SYSTEM FOR A VEHICLE AND USES OF A THERMOELECTRIC UNIT**

(71) Applicant: Volvo Car Corporation, 405 31 Göteborg (SE)
(72) Inventor: ORBAY, Raik, 40531 Göteborg (SE)
(74) Representative: Maiwald GmbH

(57) **Abstract**

The disclosure relates to a switching assembly (20) for an electric converter unit. The switching assembly (20) comprises at least one transistor unit (22) and at least one thermoelectric unit (36), wherein the at least one transistor unit (22) and the at least one thermoelectric unit (36) are thermally coupled and formed integrally. Moreover, an electric converter unit is shown. The electric converter unit comprises at least one such switching assembly (20). Additionally, a traction system for a vehicle is explained. The traction system comprising such an electric converter unit, an electric energy storage unit and an electric machine. The electric energy storage unit and the electric machine are electrically coupled to the electric converter unit. Moreover, the thermoelectric unit (36) of the electric converter unit is electrically coupled to the electric energy storage unit and/or the electric machine. Furthermore, different uses of a thermoelectric unit (36) are presented.

## Description

### TECHNICAL FIELD

The present disclosure relates to a switching assembly for an electric converter unit.

Moreover, the present disclosure is directed to an electric converter unit comprising at least one switching assembly.

Furthermore, the present disclosure relates to a traction system for a vehicle comprising an electric converter unit.

The present disclosure also relates to uses of a thermoelectric unit.

### BACKGROUND ART

In battery electric vehicles or in hybrid electric vehicles at least a portion of the energy necessary for propelling the vehicle is provided by a battery. Among other things, due to their controllability and their long service life AC electric machines have become a standard for traction systems of such vehicles. This means that each battery electric vehicle or hybrid electric vehicle comprises an electric converter unit at least configured to convert DC power provided by the battery into AC power required by the electric machine. Usually, such electric converter units are also configured to convert AC power provided by the electric machine into DC power to be stored in the battery. Consequently, the battery may be charged by the AC electric machine operating as an electric generator.

In this context, it has been found that operating the AC electric machine at high frequencies of the AC power, i.e. the current alternates at high frequencies, improves the efficiency of the electric machine and thereby increases the driving range of a vehicle equipped therewith.

### SUMMARY

It is an objective of the present disclosure to further increase the efficiency of battery electric vehicles or hybrid electric vehicles.

The problem is at least partially solved or alleviated by the subject matter of the independent claims of the present disclosure, wherein further examples are incorporated in the dependent claims.

According to a first aspect, there is provided a switching assembly for an electric converter unit. The switching assembly comprises at least one transistor unit and at least one thermoelectric unit. The at least one transistor unit and the at least one thermoelectric unit are thermally coupled and formed integrally. In this context, the use of transistor units in switching assemblies of electric converter unit is known as such. It has been found that high switching frequencies of such switching assemblies generate high switching losses. Due to the high switching losses, heat is generated by the switching assembly. However, the high switching frequencies are necessary to be able to operate the AC electric machine at high switching frequencies which renders the electric machine efficient as has been explained above. The basic idea underlying the present invention is, thus to use a thermoelectric unit such that the heat generated by the switching losses of the switching assemblies may be converted into electric energy. Thereby, the efficiency is further increased. The generated electric energy may be fed back into a battery of an electric traction system of a vehicle. This solution is particularly advantageous since the thermoelectric element converts the heat into electric energy at the same location where the heat is generated. Moreover, thermoelectric elements are comparatively compact and low-weight. This is especially the case when comparing thermoelectric elements to conventional cooling devices for switching assemblies of electric converter units. Moreover, forming the thermoelectric unit and the transistor unit integrally may be understood in that the thermoelectric unit and the transistor unit are formed as a single component. This may be done in a chip foundry. In other words, the thermoelectric unit and the transistor unit may be formed integrally on chip level. This facilitates production and further enhances the compactness of the switching assembly. If such a switching assembly is used in a battery electric vehicle or in a hybrid electric vehicle, this leads to an increased driving range. Additionally or alternatively, the electric energy generated by the thermoelectric unit may be fed back into the transistor unit. Thus, the electric energy is used for switching the transistor unit. This also enhances efficiency.

It is noted that in the context of the present disclosure, an electric converter unit may be any one or more of an AC-DC converter unit, a DC-DC converter unit, or a DC-AC converter unit.

Moreover, in accordance with the present disclosure, a thermoelectric unit is to be understood broadly as any means that is configured to transform energy in the form of heat into electric energy.

Furthermore, it is noted that the present invention may be implemented in connection with any type of transistor. This includes for example MOSFET, non-MOSFET, and non-FET solutions. Also the switching of insulated-gate bipolar transistors leads to heat generation and this may also be transferred to a thermoelectric unit.

According to an example, the transistor unit and the thermoelectric unit share a common substrate and/or a common depletion layer and/or a common heat conduction layer and/or a common die. In simplified words, the transistor unit and the thermoelectric unit are formed as an integral semiconductor component. Put otherwise, the transistor unit and the thermoelectric unit are formed on the same wafer or chip. In this context, a die is to be understood as a small block of semiconducting material on which a given functional circuit is fabricated. Thus, the production of the switching assembly is comparatively simple and the switching assembly is compact.

In an example, the thickness of the substrate is at least 200 micrometers. This facilitates the conduction of heat within the substrate.

In an example, the thermoelectric unit is a thermophotovoltaic cell or comprises a thermophotovoltaic cell. Thermophotovoltaic cells are semiconductor components which are configured to convert heat into electric energy. Thermophotovoltaic cells are comparatively efficient, i.e. heat is converted into electric energy in a comparatively efficient manner. At the same time, thermoelectric cells are very compact.

Due to the fact that the thermoelectric unit and the transistor unit are formed integrally, the thermophotovoltaic effect is incorporated seamlessly into the switching assembly which can be described as a chip in simplified words. Thus, the heat generated due to the switching losses in the infrared spectrum can be efficiently used and electric energy may be generated in the form of a flow of charges in the thermophotovoltaic cell. This increases the overall efficiency of the system, counteracting the switching losses encountered in the transistor unit.

According to an example, the transistor unit comprises at least one field effect transistor. Examples of field-effect transistors are MOSFET transistors, nMOSFET transistors, pMOSFET transistors, HEMT transistors, organic field-effect transistors and JFET transistors. Such transistors are able to be switched at high switching frequency and are comparatively efficient.

According to an example, the transistor unit is a SiC transistor unit. According to another example, the transistor unit is a SiC-MO transistor unit. According to further examples, the transistor unit comprises a dopant like GaAs, SiGe, Carbon Graphene, or GaN. Also such transistors are able to be switched at high switching frequencies and are comparatively efficient. At the same time, they can be operated at comparatively high temperatures.

According to a further example, the transistor unit may comprise a wide bandgap transistor. Alternatively, the transistor unit may be designed according to a bipolar architecture. Alternatively, the transistor unit may be designed to accommodate high electron mobility or hole mobility.

In an example, the thermoelectric unit comprises a heat exchange interface remote from the transistor unit. Using the heat exchange interface, the thermoelectric unit is configured to exchange heat with an environment. In a case in which the environment comprises a cooling system, the heat exchange interface provides a possibility to connect the thermoelectric unit to the cooling system. Consequently, heat which is not converted into electric energy by the thermoelectric unit can be used in such a cooling system. This further increases efficiency.

According to an example, the heat exchange interface comprises at least one fin. Thus, a geometric surface of the heat exchange interface is increased by the fin. This facilitates heat exchange.

According to a second aspect, there is provided an electric converter unit comprising at least one switching assembly according to the present disclosure. Thus, the heat generated by the switching losses of the switching assemblies of the electric converter may be converted into electric energy. Thereby, the efficiency is increased. The generated electric energy may be fed back into a battery of an electric traction system of a vehicle. Alternatively or additionally, the electric energy may be fed back into the transistor unit of the switching assembly. To this end, the thermoelectric unit may be electrically coupled to a gate driver of the transistor unit. There, the electric energy may be used to switch the transistor unit. In this context, the electric energy may be used to modulate the switching waveform and/or to alter a slew rate, e.g. decrease the slew rate. Due to the compactness and the efficiency of the switching assembly according to the present disclosure, also the electric converter unit is very compact and may be operated in a highly efficient manner. If such an electric converter unit is used in a battery electric vehicle or in a hybrid electric vehicle, this leads to an increased driving range.

The electric converter unit may be any one or more of an AC-DC converter unit, a DC-DC converter unit, or a DC-AC converter unit. In this context, the electric converter unit may be called a power inverter unit.

According to a third aspect, there is provided a traction system for a vehicle. The traction system comprises an electric converter unit according to the present disclosure, an electric energy storage unit and an electric machine. The electric energy storage unit and the electric machine are electrically coupled to the electric converter unit. The thermoelectric unit of the electric converter unit is electrically coupled to the electric energy storage unit and/or the electric machine. Such a traction system is highly efficient since heat generated as a consequence of switching losses in the electric converter unit may be converted into electric energy which may be fed into the electric energy storage unit or may be used in the electric machine. Alternatively or additionally, the electric energy may be fed back into the transistor unit of the switching assembly. To this end, the thermoelectric unit may be electrically coupled to a gate driver of the transistor unit. There, the electric energy may be used to switch the transistor unit. In this context, the electric energy may be used to modulate the switching waveform and/or to alter a slew rate, e.g. decrease the slew rate. As a consequence thereof, a driving range of the vehicle using the traction system is increased.

According to a fourth aspect, there is provided a use of a thermoelectric unit, especially a thermophotovoltaic cell, for cooling a transistor unit. As has been explained above, using a thermoelectric unit, especially a thermophotovoltaic cell, heat may be converted into electric energy. In other words, the thermoelectric unit may be used to withdraw heat from the transistor unit in order to generate electric energy. In other words, the thermoelectric unit may be used to cool the transistor unit.

According to a fifth aspect, there is provided a use of a thermoelectric unit, especially a thermophotovoltaic cell, for reducing switching losses of a transistor unit. As has explained above, the thermoelectric unit may withdraw heat from the transistor unit and may convert the heat into electric energy. This electric energy may be used within the system of which the thermoelectric unit and the transistor unit form part. Consequently, switching losses are reduced. At the same time, the cooling effect as such reduces the switching losses.

According to a sixth aspect, there is provided a use of a thermoelectric unit, especially a thermophotovoltaic cell, for attenuating electromagnetic interferences of a transistor unit. In this context, the thermoelectric unit may be located such that it shields electromagnetic interferences originating from the transistor unit. Alternatively or additionally, the thermoelectric unit may be producing waveforms such that it is modulated on a common mode /differential mode signal to ensure that electromagnetic interferences originating from the transistor unit are suppressed.

It should be noted that the above examples may be combined with each other irrespective of the aspect involved.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a battery electric vehicle comprising a traction system according to the present disclosure having an electric converter unit according to the present disclosure and several switching assemblies according to the present disclosure,
- Figure 2: shows one of the switching assemblies of Figure 1 in more detail, and
- Figure 3: shows a switching assembly according to another example in a view corresponding to the view of Figure 2.

### DETAILED DESCRIPTION

The Figures are merely schematic representations and serve only to illustrate examples of the disclosure. Identical or equivalent elements are in principle provided with the same reference signs.

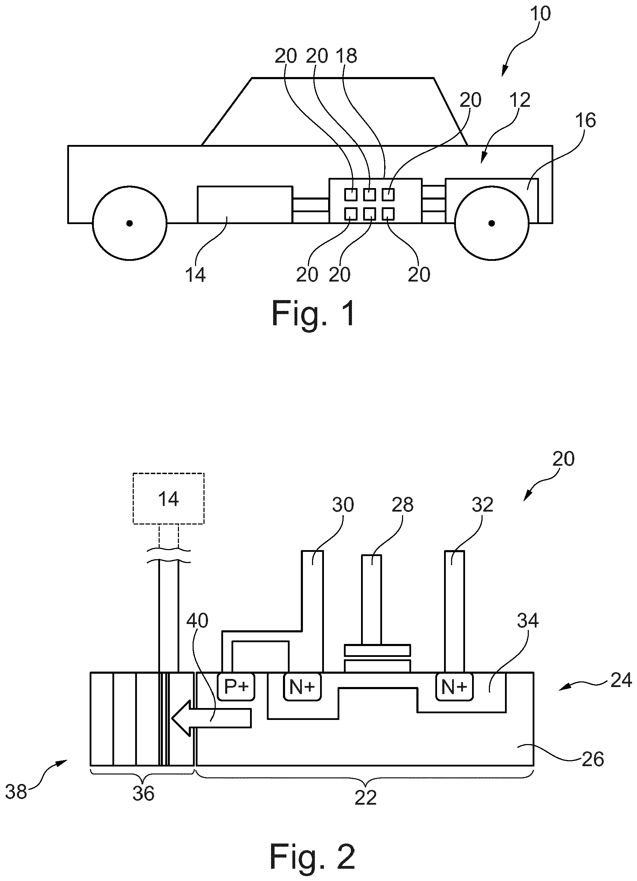

Figure 1 shows a vehicle 10 which, in the present example, is a battery electric vehicle.

Thus, the vehicle 10 comprises a traction system 12 with an electric energy storage unit 14 which may also be called a battery, an electric machine 16 and an electric converter unit 18.

The electric energy storage unit 14 and the electric machine 16 are both electrically coupled to the electric converter unit 18.

In the present example, the electric machine 16 is a 3-phase AC electric machine.

Consequently, the electric converter unit 18 is configured to convert DC power provided by the electric energy storage unit 14 into 3-phase AC power for the electric machine 16.

Moreover, the electric converter unit 18 is configured to convert 3-phase AC power generated by the electric machine 16 if the electric machine 16 operates as an electric generator into DC power to be fed into the electric energy storage unit 14.

To this end, the electric converter unit 18 comprises a total of six switching assemblies 20 wherein pairs out of the six switching assemblies 20 are associated with each of the three phases of the electric machine 16.

One switching assembly 20 is shown in more detail in Figure 2. It is noted that all six switching assemblies 20 are identical in the present example.

The switching assembly 20 comprises a transistor unit 22.

In the present example, the transistor unit 22 comprises a field effect transistor 24. It is noted that the field effect transistor is only an example. The example can as well be combined with other types of transistors.

The field effect transistor 24 is built on a substrate 26.

Moreover, it has a gate 28, a source 30 and a drain 32.

A depletion layer 34 is provided on the substrate 26.

The field effect transistor 24 may be operated in the same manner as known field-effect transistors. Thus, no further details are provided thereon.

The switching assembly 20 additionally comprises a thermoelectric unit 36.

In the present example, the thermoelectric unit 36 comprises a thermophotovoltaic cell 38.

It is noted that, due to the fact that all switching assemblies 20 are identical, all switching assemblies 20 comprise a thermoelectric unit 36 in the present example. In other examples, it is also possible that only a portion of the switching assemblies 20 is equipped with thermoelectric unit 36.

In the present example, the transistor unit 22 and the thermoelectric unit 36 share a common substrate which is the substrate 26.

More generally speaking, the transistor unit 22 and the thermoelectric unit 36 are formed integrally, e.g. simultaneously in the same chip foundry.

It is noted that in other examples, the transistor unit 22 and the thermoelectric unit 36 may alternatively or additionally share one or more of a depletion layer, a heat conduction layer or a die.

Additionally, due to the fact that the transistor unit 22 and the thermoelectric unit 36 are formed integrally, the transistor unit 22 and the thermoelectric unit 36 are thermally coupled.

Consequently, heat generated due to switching losses of the field effect transistor 24 may be transferred to the thermophotovoltaic cell 38. In Figure 2, this is illustrated by arrow 40.

The thermophotovoltaic cell 38 is configured to convert this heat into electric energy.

The thermophotovoltaic cell 38 is electrically coupled to the electric energy storage unit 14.

Consequently, the electric energy generated by the thermophotovoltaic cell 38 can be fed into the electric energy storage unit 14. Consequently, the heat generated due to the thermal losses of the field effect transistor 24 is not lost, but reused in the form of electric energy.

In other words, the thermoelectric unit 36, more precisely the thermophotovoltaic cell 38, is used for cooling the transistor unit 22.

Moreover, on the level of the electric converter unit 18 and on the level of the traction system 12, the thermoelectric unit 36, more precisely the thermophotovoltaic cell 38, is used for reducing switching losses of the transistor unit 22.

Additionally, due to the arrangement of the thermoelectric unit 36, the thermoelectric unit 36, more precisely the thermophotovoltaic cell 38, is used for attenuating electromagnetic interferences of the transistor unit 22.

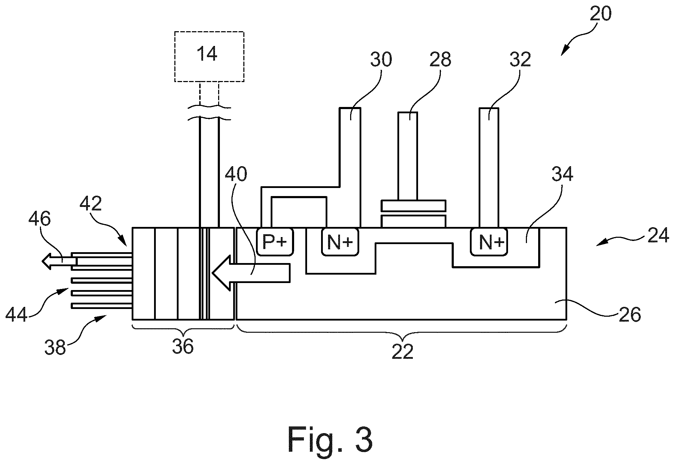

Figure 3 shows a switching assembly 20 according to another example. In the following, only the differences with respect to the example of Figure 2 will be explained.

In the switching assembly 20 of Figure 3, the thermoelectric unit 36 additionally comprises a heat exchange interface 42 remote from the transistor unit 22.

In the example shown in Figure 3, the heat exchange interface 42 and the transistor unit 22 are arranged on opposite sides of the thermoelectric unit 36.

Moreover, the fins 44 are provided on the exchange interface 42.

Consequently, in the example of Figure 3, the heat represented by arrow 40 may not be completely converted into electric energy under certain conditions.

In such conditions, excess heat, represented by arrow 46, may be provided either to an environment of the switching assembly 20 or to a cooling system of the traction system 12.

Beyond that, reference is made to the explanations provided in connection with the example of Figure 2.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope of the claims.

### LIST OF REFERENCE SIGNS

- 10: vehicle
- 12: traction system
- 14: electric energy storage unit
- 16: electric machine
- 18: electric converter unit
- 20: switching assembly
- 22: transistor unit
- 24: field effect transistor
- 26: substrate
- 28: gate
- 30: source
- 32: drain
- 34: depletion layer
- 36: thermoelectric unit
- 38: thermophotovoltaic cell
- 40: arrow
- 42: heat exchange interface
- 44: fin
- 46: arrow

## Claims

1. A switching assembly (20) for an electric converter unit (18), comprising at least one transistor unit (22) and at least one thermoelectric unit (36), wherein the at least one transistor unit (22) and the at least one thermoelectric unit (36) are thermally coupled and formed integrally.

2. The switching assembly (20) of claim 1, wherein the transistor unit (22) and the thermoelectric unit (36) share a common substrate (26) and/or a common depletion layer and/or a common heat conduction layer and/or a common die.

3. The switching assembly (20) of any of the preceding claims, wherein the thermoelectric unit (36) is a thermophotovoltaic cell (38) or comprises a thermophotovoltaic cell (38).

4. The switching assembly (20) of any one of the preceding claims, wherein the transistor unit (22) comprises at least one field effect transistor (24).

5. The switching assembly (20) of any one of the preceding claims, wherein the thermoelectric unit (36) comprises a heat exchange interface (42) remote from the transistor unit (22).

6. The switching assembly (20) of claim 5, wherein the heat exchange interface (42) comprises at least one fin (44).

7. An electric converter unit (18) comprising at least one switching assembly (20) according to any of the preceding claims.

8. A traction system (12) for a vehicle (10) comprising an electric converter unit (18) according to claim 7, an electric energy storage unit (14) and an electric machine (16), wherein the electric energy storage unit (14) and the electric machine (16) are electrically coupled to the electric converter unit (18) and wherein the thermoelectric unit (36) of the electric converter unit (18) is electrically coupled to the electric energy storage unit (14) and/or the electric machine (16).

9. A use of a thermoelectric unit (36), especially a thermophotovoltaic cell (38), for cooling a transistor unit (22).

10. A use of a thermoelectric unit (36), especially a thermophotovoltaic cell (38), for reducing switching losses of a transistor unit (22).

11. A use of a thermoelectric unit (36), especially a thermophotovoltaic cell (38), for attenuating electromagnetic interferences of a transistor unit (22).
